# EUROPEAN PATENT APPLICATION

(11) **EP 4 844 805 A1**
(43) Date of publication of application: **25.11.2026**
(21) Application number: 25178380.9
(22) Date of filing: 22.05.2025
(51) Int. Cl.: H01J 37/30, H01J 37/304, H01J 37/305

(54) **ION MILLING APPARATUS AND METHOD, IMAGE PROCESSING APPARATUS AND METHOD**

(71) Applicant: Leica Mikrosysteme GmbH, 1170 Wien (AT)
(72) Inventor: WELLER, Miriam, 1170 Wien (AT); KATZENGRUBER, Matthias, 1170 Wien (AT)
(74) Representative: 2SPL Patentanwälte PartG mbB

(57) **Abstract**

It is provided an ion milling apparatus. The ion milling apparatus comprises an ion source configured to form an ion beam from plasma and radiate the ion beam towards a sample for generating an ablation region. The ion beam emits light towards the sample. The ion milling apparatus further comprises an optical imaging sensor configured to capture the light from the ablation region.

## Description

### Technical field

Examples relate to material removal techniques, more particularly, to apparatuses and methods for monitoring ion-beam etching processes.

### Background

In conventional production lines, process control of ion-beam etching is performed on an open-loop basis: the operator specifies a fixed dwell time for each etch step, e.g., calculated from empirical removal rates at a given ion energy and incidence angle. This time-based approach is simple to implement but suffers from fundamental limitations: Etch rates vary from sample to sample due to changes in substrate composition, topology, and crystal orientation, or due to contamination and beam drift, so the preset time rarely matches the true removal depth. The result is either residual material from under-etching or feature loss, redeposition, and yield loss from over-etching.

Accordingly, there exists a need for improved determination of an etching progress.

### Summary

This need is satisfied by the subject matter of the independent claims. It is a finding of the inventors that analyzing camera images of the sample improves the etching progress observation.

Examples provide an ion milling apparatus. The ion milling apparatus comprises an ion source configured to form an ion beam from plasma and radiate the ion beam towards a sample for generating an ablation region. The ion beam (is configured to emit or) emits light towards the sample. The ion milling apparatus further comprises an optical imaging sensor configured to capture the light from the ablation region. The light may originate from the ion beam and/or from the plasma.

The ion milling apparatus provides an automated, in-situ, non-contact monitoring technique for observing the etch progress continuously. The etch progress can be used to adapt automatically to variations in substrate behavior. Real-time feedback lets the control system adjust parameters - or halt the run - the moment the target depth is reached. The apparatus further integrates with existing industrial ion-beam tools without extensive hardware modification. By estimating the remaining process time, users can also schedule their workload and tool utilization more efficiently.

The optical radiation (light) produced by the ion beam may be visible (VIS) and/or infrared (IR) light or may span to other or further spectral ranges. This may depend on the substrate material, beam energy, and chamber atmosphere. Its intensity can be time-varying, for example, pulsing with beam current fluctuations, or essentially stationary, and may range from a very weak glow just above the sensor's noise floor to a strong emission that approaches detector saturation. The imaging sensor and associated processing circuitry may therefore be designed to accommodate both variable and constant light levels across a broad intensity spectrum.

**In** an example, the ion milling apparatus has no other light source except the ion beam and optionally the plasma within a vacuum chamber of the ion milling apparatus. That is, the ion beam and optionally the plasma serve as the sole illumination source inside the vacuum chamber. The ion beam and optionally the plasma are configured to provide both material removal and all optical illumination within the vacuum chamber. Thus, illumination of the workpiece (sample) is generated exclusively by photons emitted from the ion beam and/or the plasma during operation. The vacuum chamber is substantially free of auxiliary lighting.

Conventionally, images of a sample may be made by using external light sources. Relying solely on the ion beam for illumination removes the need for auxiliary lamps or fiber-optic feedthroughs. This simplifies the chamber hardware, reducing out-gassing and contamination sources, and ensures that photons captured by the camera originate from the active milling zone (ablation region). Thereby, both vacuum integrity and measurement fidelity are enhanced.

Alternatively, the image captured by the optical imaging sensor is substantially derived from the light (from photons generated by the ion beam and/or the plasma). Any auxiliary light source would contribute no more than a negligible fraction of the total optical power incident on the sample.

**In** an example, the ion milling apparatus further comprises a sample holder configured to hold the sample, and a mask configured to protect predefined regions of the sample. This arrangement enables selective, high-precision etching by milling only the exposed areas while safeguarding protected regions.

Examples provide an image processing apparatus comprising processing circuitry. The processing circuitry is configured to obtain an image of the light captured by the optical imaging sensor of the ion milling apparatus as described herein. The processing circuitry is further configured to determine a spatial dimension of the ablation region based on the image.

The image processing apparatus can extract the ablation region's width, length, or depth directly from live optical images in a non-contact manner. This eliminates destructive post-etch measurements and shortens feedback loops. By quantifying the ablated area on-the-fly, the control system can adjust beam parameters or terminate the run exactly at the target dimension. Continuous dimension tracking makes the process self-adaptive to etching variations, e.g., due to ion-beam drift, substrate irregularities, or mask misalignment without operator intervention.

Optionally, image-processing routines may be applied to the image by the processing circuitry, e.g., if the image comprises or is raw optical data. For instance, the captured frame may be first de-noised and then enhanced, for example, by automatic contrast and color correction. The processing circuitry may further or alternatively process the image to include an analytical overlay that, e.g., highlights or quantifies key metrics of the ablation region such as geometry, side-wall angle, or instantaneous feed rate.

In an example, the processing circuitry is further configured to obtain a plurality of images of the light captured by the optical imaging sensor, determine the spatial dimension of the ablation region for the plurality of images, and estimate a milling speed or a milling progress based on the determined spatial dimension. By tracking the growing of the ablation region, e.g., frame-by-frame, the live speed of the etch can be gained. This lets the user predict completion time, spot drift or tool wear, and adjust parameters before defects arise.

In an example, the processing circuitry is configured to estimate a total milling time or a time of a predefined future milling progress (e.g., completion of a certain milling step) based on the milling speed or the milling progress. This may be done by applying an interpolation, extrapolation, regression or alike to the milling speed or the milling progress. This prediction of the remaining milling time gives users advance notice to, e.g., stage the next wafer, adjust upstream logistics, or intervene in other ways.

In order to implement closed-loop control of the etch process, the processing circuitry may compare, e.g., continuously or at a predefined time instance, the measured milling progress to a predefined target value or set-point for the desired etch depth and profile. A deviation between the actual and desired values generates an error signal, which is then converted into a feedback command. This command may adjust ion-beam parameters such as beam current, dwell time, scan rate or pattern, and mask alignment, thereby driving the error toward zero. By iterating this measure-compare-adjust cycle at regular intervals, the system self-corrects for sample-to-sample variability, beam drift, and process nonlinearities, ensuring that the etch completes (exactly and only) when the intended region of interest has been exposed.

In an example, the processing circuitry is configured to linearly or exponentially interpolate the milling speed or the milling progress. Depending on the specific etching step, a suitable interpolation or regression can be selected. E.g., for longer processes, an exponential-based curve can be chosen for the regression to account for the nonlinear behavior of the milling speed.

In an example, the processing circuitry is configured to determine the spatial dimension by fitting a predetermined function to an intensity distribution of the light in the image. For example, the predetermined function may be a Gaussian function. Using a fitted function such as a Gaussian extracts the ablation-region size very reliably. Further, sub-pixel accuracy and higher noise immunity can be reached in comparison to simple thresholding.

In an example, the processing circuitry is configured to determine the spatial dimension by determining a peak of the fitted predetermined function. Locating the peak of the fitted function pinpoints the ablation region's center with high precision even when, e.g., edges are blurred or partially obscured.

In an example, the processing circuitry is further configured to project the intensity distribution onto an axis and fit the predetermined function to the projected intensity distribution. This projection simplifies the data for faster, noise-resilient dimension estimates.

In an example, the processing circuitry is further configured to determine the spatial dimension of the ablation region by locating a local maximum of a spatial intensity distribution of the light in the image. This direct location of a local maximum may be applied alternatively or additionally to a fitting method as described above. By directly pinpointing the local intensity maximum, faster width measurements are achieved with lower computational overhead. Errors or delays associated with curve-fitting routines are avoided.

In an example, the processing circuitry is configured to determine a spatial dimension of a trench milled into the sample. Optically monitoring a trench with the very ion beam that mills it is specifically beneficial since the illumination reaches the bottom of a deep, narrow groove, whereas external lamps strike the wafer at an oblique angle, so their light is largely blocked by the trench walls.

Generally, because illumination is produced where sputtering occurs, the brightest signal marks the active milling front, making depth and width measurements unambiguous. Collinear beam-and-camera geometry eliminates side-illumination shadows, enabling accurate dimensional fits from a single 2-D image or its 1-D projection. Also, background light from the surrounding areas can be held minimally for strengthening optical contrast. Avoiding auxiliary lamps removes extra feed-throughs and heat sources for reducing contamination risk.

Examples provide an alternative or additional configuration of the ion milling apparatus above. The alternative configuration is an ion milling apparatus comprising an ion source configured to form an ion beam from plasma and radiate the ion beam towards a sample for generating an ablation region. The ion milling apparatus further comprises an optical imaging sensor configured to capture light being produced by an interaction of the ion beam with the ablation region.

The light detected by the optical imaging sensor may originate from any photon-emitting interaction that occurs when the ion beam strikes the sample. Relevant mechanisms include, but are not limited to, ion-induced luminescence (IIL) (in which impinging ions excite electronic states of surface atoms; the subsequent radiative relaxation produces characteristic line or band emission extending from the ultraviolet into the near-infrared), cathodoluminescence generated by secondary electrons liberated during sputtering (these electrons penetrate a short distance into the substrate, excite deeper electronic states, and emit visible or near-infrared photons upon recombination, providing depth-sensitive information), glow from the sputter plume (where neutral atoms ejected from the surface collide with residual gas and form a local micro-plasma that radiates a broadband continuum together with element-specific lines; the intensity of this glow may be proportional to the instantaneous sputter yield), continuum emission (Bremsstrahlung) (this emission arises from the deceleration of charged particles in the near-surface electric fields; this extends from X-ray to visible wavelengths and serves as a proxy for beam-energy density), thermoluminescence or black-body micro-hot-spot emission (this is produced when localized ion-beam heating raises the trench floor or walls to incandescent temperatures, typically emitting in the red-visible to infrared range). Any one of these phenomena, or a combination thereof, furnishes a photon flux that is co-located with the active ablation region. The optical signal captured by the imaging sensor constitutes a direct, real-time proxy for material removal, enabling the imaging sensor and associated processing circuitry to monitor, e.g., trench formation with high spatial and temporal fidelity while requiring no auxiliary light source inside the vacuum chamber.

Examples provide an ion milling method. The method comprises forming an ion beam from plasma and radiating the ion beam towards a sample for generating an ablation region. The ion beam emits light towards the sample. The method further comprises capturing the light, by an optical imaging sensor.

Examples provide an alternative or additional ion milling method. The method comprises forming an ion beam from plasma, radiating the ion beam towards a sample for generating an ablation region and capturing light being produced by an interaction of the ion beam with the ablation region.

Examples provide an image processing method. The method comprises obtaining an image of the light captured by the optical imaging sensor of the ion milling apparatus described herein, and determining a spatial dimension of the ablation region of the sample based on the image.

Examples further relate to a computer program having a program code for performing the image processing method described herein, when the computer program is executed on a computer, a processor, or a programmable hardware component.

### Short description of the Figures

Some examples of apparatuses and/or methods will be described in the following by way of example only, and with reference to the accompanying figures, in which
Fig. 1 shows a schematic illustration of an example of an ion milling apparatus;
Fig. 2 shows an example of an image captured by an optical imaging sensor;
Fig. 3 shows a block diagram of an example of an image processing apparatus;
Fig. 4 shows a diagram of an example of projected intensity profiles and their Gaussian fits;
Fig. 5 shows a plot of an example of a milling speed;
Fig. 6 shows a flow chart of an example of an ion milling method;
Fig. 7 shows a flow chart of an example of an image processing method;
Fig. 8a shows a schematic diagram of an example of an ion milling system during ion milling of a sample; and
Fig. 8b shows a schematic diagram of an example of an ion milling system during observation of a sample.

### Detailed Description

As used herein the term "and/or" includes any and all combinations of one or more of the associated listed items and may be abbreviated as *"*/*".*

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Various examples will now be described more fully with reference to the accompanying drawings in which some examples are illustrated. In the figures, the thicknesses of lines, layers and/or regions may be exaggerated for clarity.

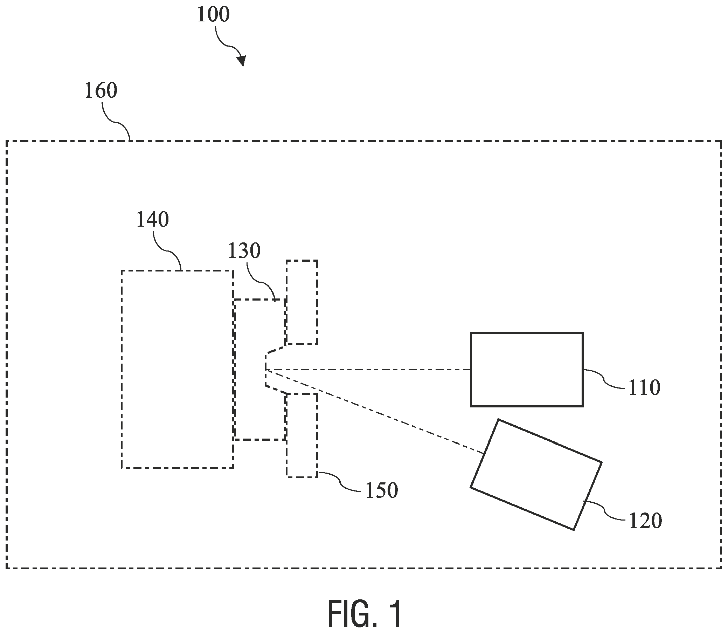

Fig. 1 shows a schematic illustration of an example of an ion milling apparatus 100. The ion milling apparatus 100 is a machine that removes material from a solid sample 130 by directing a collimated or focused beam of energetic ions - typically but not exclusively noble-gas species - onto the sample surface. During operation the ion beam sputters atoms from exposed regions of the sample 130, enabling tasks such as surface cleaning, pattern transfer, cross-sectioning, thinning or nano-scale machining. Usually, the sample 130 is housed in a vacuum chamber 160 under low-pressure conditions (≈10⁻⁴ mbar or better) to reduce ion scattering.

A core part of the ion milling apparatus 100 is the ion source 110. The ion source 110 is configured to form an ion beam from plasma. Inside a discharge chamber, a neutral working gas is ionized by an electric field. The result is a mixture of positively charged ions, electrons, and neutral atoms - the plasma. The ion source 110 then extracts, e.g., by a series of biased electrodes, positive ions from the plasma. By applying a high voltage, the ions can be accelerated along a straight path. Electrostatic or magnetic lenses hone the ion trajectories into a narrow, collimated ion beam.

The ion source 110 is configured to radiate the ion beam towards the sample 130 for generating an ablation region. For instance, the ion source 110 may comprise beam-steering plates, magnetic deflectors, electrodes or lenses that steer, raster or align the ion beam over the sample surface. By "radiating" the beam toward the sample 130, the ions' kinetic energy is concentrated on a localized spot or pattern on the surface. When these high-energy ions hit the sample 130, they sputter away atoms in that targeted area, creating the "ablation region" - the zone where material is being milled or etched.

The ion milling apparatus 100 further comprises an optical imaging sensor 120 configured to capture light emanating from the ablation region. That is, the ion milling apparatus 100 includes a camera (or other light detector) recording the spot where ions are milling the surface. The ion beam and/or the plasma themselves emit the light towards the sample 130 and/or the light is produced by an interaction of the ion beam with the ablation region. In the latter case, ions - when striking and sputtering material from the sample 130 - generate photons (e.g., via luminescence, sputter-plume glow, thermal emission, etc.).

The optical radiation (the light) may be visible and/or infrared light or may be part of other or further spectral ranges. This may depend on the substrate material, beam energy, and chamber atmosphere. Its intensity can be time-varying, for example, pulsing with beam current fluctuations, or essentially stationary, and may range from a very weak glow just above the sensor's noise floor to a strong emission that approaches detector saturation. The imaging sensor 120 and associated processing circuitry may be designed to accommodate variable and/or constant light levels across a broad intensity spectrum.

The optical imaging sensor 120 is positioned, oriented and focused, optionally with the help of additional optical components, so it "sees" that ablation region and records the emitted light. The optical imaging sensor 120 may, for instance, be positioned inside the vacuum chamber and may be radiation-hardened, e.g., behind a small protective window or light pipe. Then, the optical imaging sensor 120 may be positioned close to the ablation region and oriented directly towards it for increasing photon collection and decreasing optical aberrations. The optical imaging sensor 120 may alternatively be positioned outside the vacuum chamber, e.g., with the sensor 120 having a substantially coaxial alignment with the ion beam axis. This may give a nearly undistorted view of the beam impact spot. However, there are numerous other installation possibilities for the optical imaging sensor 120, e.g., realization of an oblique side-view via a dedicated port when the objective lens is mounted at an angle from vertical on a side flange, or realization of a remote view via mirror or fiber-optic relay redirecting the emitted light an external camera for isolating sensitive electronics from the vacuum and ion flux.

By capturing this light, the apparatus 100 can gain a direct, non-contact view of the milling action, enabling downstream image processing and process control based on the milling progress.

Optionally, the ion milling apparatus 100 has no other light source but the ion beam, the plasma and/or the interaction of the ion beam with the ablation region within the vacuum chamber 160 of the ion milling apparatus 100. That is, the ion beam and/or the plasma (and/or the interaction) serves as the sole illumination source inside the vacuum chamber 160. The ion beam and/or plasma are configured to provide both material removal and (optionally via the interaction with the sample 130) all optical illumination within the vacuum chamber. Thus, illumination of the workpiece (sample) is generated exclusively by photons emitted from the ion beam and the plasma or the sputtering. The vacuum chamber 160 then is substantially free of auxiliary lighting.

Alternatively, the image captured by the optical imaging sensor 120 is substantially derived from the light (from photons generated by the ion beam, the plasma and/or the interaction with the sample 130). Any auxiliary light source would contribute no more than a negligible fraction of the total optical power incident on the sample 130.

The ion milling apparatus 100 may further comprise a sample holder 140 configured to hold the sample 130 and a mask 150 configured to protect predefined regions of the sample 130. The sample holder 140 may be a mechanical stage or chuck that rigidly secures the workpiece 130 in the correct position and orientation under the ion beam. The mask 150 may be a patterned barrier, such as a metal or ceramic plate with apertures, a photoresist stencil, or a shadow-mask, that covers and shields specific regions of the sample 130 from ion impact. Only the exposed areas (the "windows" in the mask) are etched, allowing selective milling of complex patterns without moving or re-masking the sample 130.

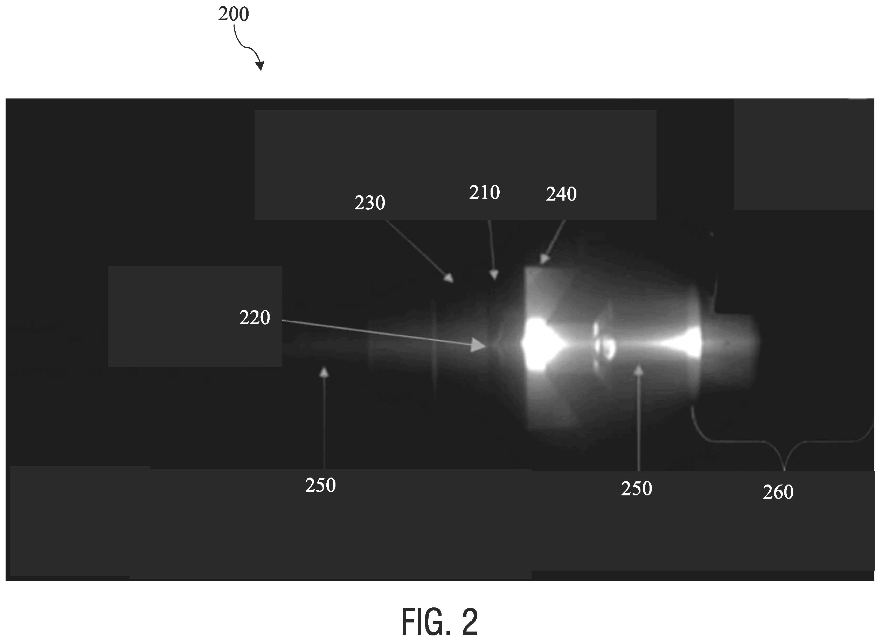

An example of an image 200 captured by the optical imaging sensor 120 is illustrated by Fig. 2. The image 200 shows a top-view observation of a silicon sample 210 during an ion beam cross-sectioning process. The process forms an etching trench 220 into the sample 210. The light captured in the image 200 is due to the reflection of the very bright ion beam at the sloping etching trench 220 that develops during the process. The image 200 further shows a sample holder 230, a mask 240, the ion beam (Argon) 250, and the ion source 260.

Analysis of such an image 200 at different points in time (for instance, every 5 minutes) can yield insights into the current ion milling speed and projections onto its future development.

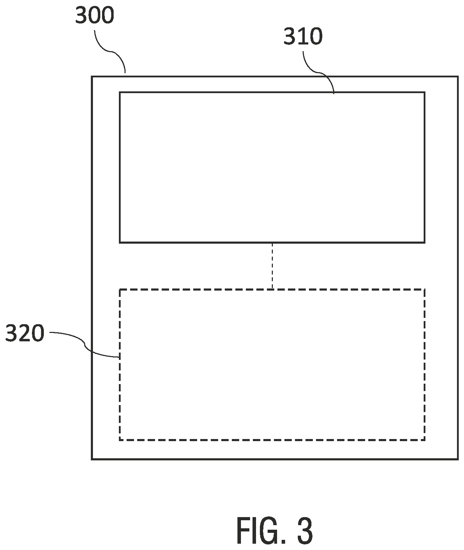

An example of how such an image 200 or any other image captured by an optical imaging sensor, as described herein, can be processed, is illustrated by Fig. 3. Fig. 3 shows a block diagram of an example of an image processing apparatus 300 comprising processing circuitry 310.

The image processing apparatus 300 is an apparatus for image processing. For instance, the apparatus 100 may implement a sequence of computational operations applied to raw or preprocessed (e.g., digital) images in order to enhance their quality, extract meaningful information, or prepare them for further analysis. The processing circuitry 310 may comprise hardware, software and/or firmware (or embedded software) for executing computational tasks within the apparatus 300. The processing circuitry 310 may include, e.g., one or more processors (e.g., CPUs (central processing units), microcontrollers, or FPGAs (field-programmable gate arrays)) that run algorithms to analyze incoming image data, memory modules (RAM (random-access memory, flash) to store program code or intermediate results and power regulation and timing circuitry to ensure synchronized acquisition, processing, and feedback.

The image processing apparatus 300 may optionally comprise interface circuitry 320 coupled to the processing circuitry 310. The interface circuitry 320 may, for instance, include any interface (e.g., high-speed data buses, camera links) to receive an image, e.g., in form of a pixel stream, from the optical imaging sensor and send the received image to the processing circuitry 310. Optionally, the interface circuitry 320 may send control signals to the ion-beam source or sample stage.

The processing circuitry 310 is configured to obtain an image of the light captured by the optical imaging sensor of the ion milling apparatus as described herein, such as the ion milling apparatus 100. For instance, the processing circuitry 310 may receive said image via the interface circuitry 320 from the optical imaging system or memory saving the image. Alternatively, the processing circuitry 310 may determine said image without an interface, if integrated into the optical imaging sensor or a system comprising the optical imaging system.

The processing circuitry 310 is further configured to determine a spatial dimension of the ablation region based on the image. For instance, the processing circuitry 310 can extract the ablation region's width, length, depth or any other dimension from the image.

The spatial dimension may be determined by any adequate algorithm, for instance, (e.g., gradient-based edge) detection, binary segmentation and distance transform, or using image moments or variances. An advantageous approach is the usage of a fitting algorithm. In such a case, the processing circuitry 310 is configured to determine the spatial dimension by fitting a predetermined function to an intensity distribution of the light in the image. For instance, a line profile (or full 2D map) of pixel intensities over the ablation region may be extracted. It is assumed it follows a known shape, e.g., a Gaussian "bump." By least-squares (or maximum-likelihood) fitting the function's parameters (amplitude, center, width) may be recovered, and the width parameter maps to the spatial dimension.

The predetermined function may in one example be a Gaussian function. Alternatives may be Lorentzian or Voigt fits for heavier tails or mixed broadening, error-function fits if a step-edge convolved with blur is expected, or polynomial or spline fits to capture asymmetric profiles.

The spatial dimension may, for instance, be determined by determining (or locating) a peak of the fitted predetermined function. Once the parametric fit is finished, the "peak" parameter may be determined which corresponds to the brightest spot in the ablation region. Then, widths (e.g. full-width at half-maximum) relative to that spot can be measured. Alternatively, threshold-based edge detection, sub-pixel centroiding or alike may be applied to the fitted function.

Optionally, as preparation for the above fitting, the intensity distribution may be projected onto an axis and the function may then be fitted to that projection. For an elongated feature (like a trench), the 2D intensity can be summed or averaged in the lengthwise direction to collapse into a single 1D profile across the width. The Gaussian (or other) model may then be applied to that reduced dataset for improving noise immunity and speeding up computation. Alternatively, full 2D surface fitting may be implemented, i.e., an anisotropic Gaussian or rotated 2D model may directly be applied to the unprojected intensity distribution.

In an example, the processing circuitry 310 may be configured to determine a spatial dimension of a trench milled into the sample. The above profiling/fitting methods may be applied specifically to a linear, high-aspect-ratio ablation groove. The output can be the trench width or depth.

Optionally, image-processing routines may be applied to the image by the processing circuitry, e.g., if the image comprises or is raw optical data. For instance, the captured frame may be first de-noised and then enhanced, for example, by automatic contrast and color correction. The processing circuitry may further or alternatively process the image to include an analytical overlay that, e.g., highlights or quantifies key metrics of the ablation region such as geometry, side-wall angle, or instantaneous feed rate.

For continuous monitoring of the ablation region, the processing circuitry 310 may be further configured to obtain a plurality of images of the light captured by the optical imaging sensor, determine the spatial dimension of the ablation region for the plurality of images, and estimate a milling speed or a milling progress based on the determined spatial dimension. For instance, the optical imaging system may continuously capture a series of images as the ion beam mills the sample, yielding the plurality of images. For instance, for each frame, the circuitry 310 may apply the chosen measurement algorithm (e.g. Gaussian-fit) to compute the current dimension of the ablation region. By comparing the change in measured dimension between successive frames and dividing by the elapsed time, it calculates an etch rate (e.g. micrometers per second). By relating the current dimension to the target (or to the initial sample thickness), it determines how far the process has advanced - as an absolute material-removed value or as a percentage toward the end-point.

By, e.g., applying an interpolation, extrapolation or regression to the milling speed or the milling progress, the processing circuitry 310 may estimate a total milling time or a time of a predefined future milling progress (e.g., completion of a certain milling step). This prediction of the remaining milling time gives users advance notice to, e.g., stage the next wafer, adjust upstream logistics, or intervene in other ways. The regression or interpolation may, for instance, be linear or exponential.

A concrete implementation may be as follows: Captured images may be processed in real time by an analysis algorithm that first crops each frame to the region containing the mask and sample and then converts pixel measurements into micrometers using a known scale. From this cropped area, the algorithm isolates the central trench segment, projects its intensity values onto a cross-sectional axis by summing along the trench length, and fits a Gaussian (or equivalent) function to the resulting one-dimensional profile. The peak position of that fit is timestamped and compared to its initial value to determine the absolute displacement of the ablation front since the start of milling. By plotting these peak positions against elapsed time and applying a regression model - linear for short, stable runs or exponential to accommodate the non-linear behavior of longer processes - the apparatus 300 derives the instantaneous milling speed and forecasts future progress.

This projection-and-fit procedure is repeated at three or more lateral locations across the trench in each image, and a two-dimensional model is fitted to those extracted points to reconstruct the trench's width and side-wall geometry at that moment. With each new image, the two-dimensional profile and the regression-based forecast of the final shape are updated on the fly, providing operators with continuous etch-rate measurements, dynamically refined completion-time estimates, and evolving trench profiles.

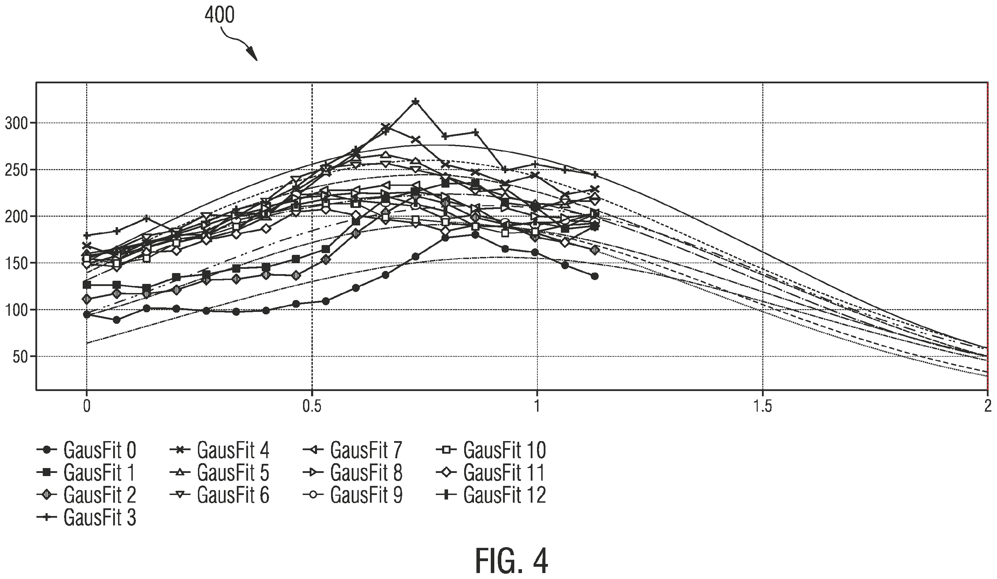

Fig. 4 illustrates a diagram 400 of an example of projected intensity profiles (dots) extracted from an image as described herein and their Gaussian fits (solid curves). This plot 400 overlays a series of 1D intensity profiles their fits, each corresponding to a successive image of the trench cross-section. The horizontal axis is the lateral position across the trench (in normalized units), and the vertical axis is pixel intensity. Thirteen datasets (GausFit 0 through GausFit 12) are shown, with projected data shown as scattered markers and the smooth Gaussian models fitted through them. As the etch proceeds, the peak intensity grows to a maximum (around x≈0.6-0.8) and then slowly diminishes, while the width of the fitted Gaussian also subtly changes - together tracking how the ablation region's size and brightness evolve over time. This visualization demonstrates the Gaussian-fit approach and the dynamic behavior of the trench-milling process.

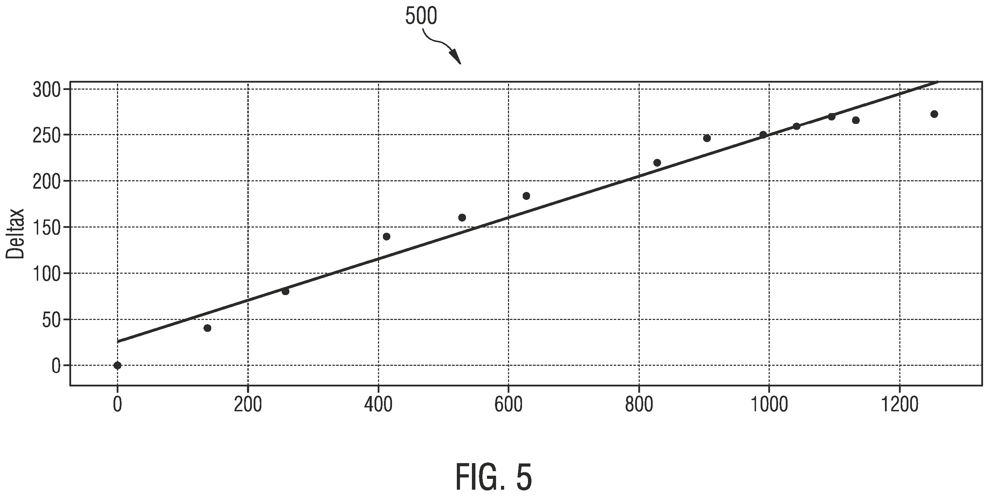

Fig. 5 illustrates a plot 500 of an example of a milling speed, extracted by the methods described herein. This scatter plot 500 shows how the fitted trench-peak position ("Δ x" on the vertical axis, in picometers) evolves over time (horizontal axis, in seconds). Each dot represents the displacement measured in one frame, and the straight line is a linear regression through those points. The slope of that line corresponds to an etch rate of roughly 809 pm per hour.

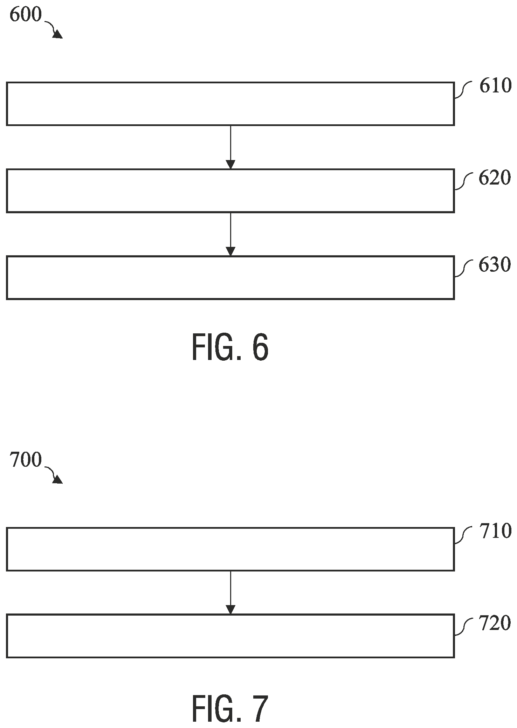

Fig. 6 illustrates a flowchart of an example of an ion milling method 600. The method 600 comprises forming 610 an ion beam from plasma and radiating 620 the ion beam towards a sample for generating an ablation region. The ion beam emits light towards the sample. The method 600 further comprises capturing 630 the light, by an optical imaging sensor.

An alternative method to the method 600 comprises forming an ion beam from plasma, radiating the ion beam towards a sample for generating an ablation region and capturing light being produced by an interaction of the ion beam with the ablation region.

Fig. 7 illustrates a flowchart of an example of an image processing method 700. The method 700 comprises obtaining 710 an image of the light captured by the optical imaging sensor of the ion milling apparatus described herein, and determining 720 a spatial dimension of the ablation region of the sample based on the image.

Some or all of the method steps may be executed by (or using) a hardware apparatus, like for example, a processor, a microprocessor, a programmable computer or an electronic circuit. In some embodiments, some one or more of the most important method steps may be executed by such an apparatus.

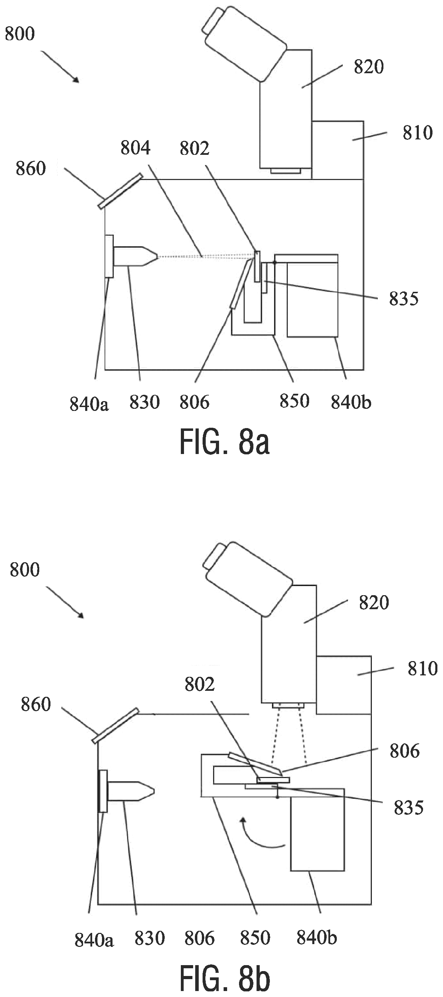

Fig. 8a shows a schematic diagram of an example of an ion milling system 800 during ion milling of a sample 802. An ion milling system 800 typically comprises several components. These include at least one ion emitter 830, which comprises the ion source that generates the ion beam 804 (commonly using Argon gas) and ion optics, which are used to direct the ion beam 804 onto the sample 802. A mechanical ion beam positioning system 840a is used to target the sample 802 by adjusting at least one of a lateral position, vertical position, or orientation of the at least one ion emitter 830.

A sample stage 850 holds and precisely positions the sample during processing. The sample 802 is attached to a sample holder 835, which is mounted to the sample stage 850. A mask 806 partially shields the sample 802 during ion milling. A mechanical sample stage positioning system 840b is used to position the sample stage 850 with the sample 802 relative to the ion beam 804, with the mechanical sample stage positioning system 840b being configured to adjust at least one of a lateral position, vertical position, or orientation of the sample stage 850, and therefore of the sample 802. The ion milling system 800 may also use vacuum equipment to maintain vacuum conditions, as discussed herein. Finally, a control system 810 controls the operation and parameters of the ion milling process, allowing for adjustments to be made for different applications and material types. The control system 810 can be controlled via a touch-screen display 860, which is coupled to the control system 810.

In the ion milling system 800 shown in Figs. 8a and 8b, a digital or hybrid microscope 820 allows a user to inspect the sample 802 that is placed on the sample stage 850. The control system 810 uses image data from the microscope 820, which performs the function of an imaging device. Alternatively, a camera may be placed in the chamber of the ion milling system 800 and be used to monitor the sample before and after the ion milling. As the sputtering leads to deposition of material removed from the sample on the components inside the ion milling chamber, the camera may be shielded from the sample chamber during ion milling, e.g., using a retractable shield, which may be removed periodically or occasionally to allow for monitoring of the progress of the ion milling process.

As shown in Fig. 8b, the sample stage 850 may be moved (e.g., tilted) towards the imaging device, e.g., the microscope 820, for observation. Fig. 8b shows a schematic diagram of an example of an ion milling system 800 during observation of a sample 802, when using the microscope 820 as the imaging device. To allow for observation of the sample 802, the sample stage 850 is tilted upwards by 90 degrees, such that the ion emitter-facing side of the sample now faces towards the microscope 820. As the sample is partially shielded by the mask06, the image data further shows the mask 806 for shielding a further portion of the sample 802.

Depending on certain implementation requirements, embodiments of the invention can be implemented in hardware or in software. The implementation can be performed using a non-transitory storage medium such as a digital storage medium, for example a floppy disc, a DVD, a Blu-Ray, a CD, a ROM, a PROM, and EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may, for example, be stored on a machine readable carrier.

Other embodiments comprise the computer program for performing one of the methods described herein, stored on a machine readable carrier.

In other words, an embodiment of the present invention is, therefore, a computer program having a program code for performing one of the methods described herein, when the computer program runs on a computer.

A further embodiment of the present invention is, therefore, a storage medium (or a data carrier, or a computer-readable medium) comprising, stored thereon, the computer program for performing one of the methods described herein when it is performed by a processor. The data carrier, the digital storage medium or the recorded medium are typically tangible and/or non-transitionary. A further embodiment of the present invention is an apparatus as described herein comprising a processor and the storage medium.

A further embodiment of the invention is, therefore, a data stream or a sequence of signals representing the computer program for performing one of the methods described herein. The data stream or the sequence of signals may, for example, be configured to be transferred via a data communication connection, for example, via the internet.

A further embodiment comprises a processing means, for example, a computer or a programmable logic device, configured to, or adapted to, perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example, a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

The aspects and features described in relation to a particular one of the previous examples may also be combined with one or more of the further examples to replace an identical or similar feature of that further example or to additionally introduce the features into the further example.

### List of reference Signs

100 apparatus
110 ion source
120 optical imaging sensor
130 sample
140 sample holder
150 mask
160 vacuum chamber
200 image
210 sample
220 trench
230 sample holder
240 mask
250 ion beam
260 ion source
300 imaging processing apparatus
310 processing circuitry
320 interface circuitry
400 Gaussian fit
500 milling speed
600 ion milling method
610 forming
620 radiating
630 capturing
700 imaging processing method
710 obtaining
720 determining
800 ion milling system
802 sample
804 ion beam
806 mask
810 control system
820 digital or hybrid microscope
830 ion emitter / ion source
835 sample holder
840a mechanical ion-beam positioning system
840b mechanical sample-stage positioning system
850 sample stage
860 touch-screen display

## Claims

1. An ion milling apparatus (100), comprising:
an ion source (110) configured to form an ion beam from plasma and radiate the ion beam towards a sample (130) for generating an ablation region, wherein the ion beam emits light towards the sample (130); and
an optical imaging sensor (120) configured to capture the light from the ablation region.

2. The ion milling apparatus (100) according to claim 1, wherein
the ion milling apparatus (100) has no other light source except the ion beam within a vacuum chamber (160) of the ion milling apparatus (100).

3. The ion milling apparatus (100) according to any one of the preceding claims, further comprising
a sample holder (140) configured to hold the sample (130); and
a mask (150) configured to protect predefined regions of the sample (130).

4. An image processing apparatus (300) comprising processing circuitry (310) configured to:
obtain an image of the light captured by the optical imaging sensor of the ion milling apparatus according to any one of claims 1 to 3; and
determine a spatial dimension of the ablation region based on the image.

5. The image processing apparatus (300) according to claim 4, wherein the processing circuitry (310) is further configured to:
obtain a plurality of images of the light captured by the optical imaging sensor;
determine the spatial dimension of the ablation region for the plurality of images; and
estimate a milling speed or a milling progress based on the determined spatial dimension.

6. The image processing apparatus (300) according to claim 5, wherein the processing circuitry (310) is configured to estimate a total milling time or a time of a predefined future milling progress based on the milling speed or the milling progress.

7. The image processing apparatus (300) according to claim 6, wherein the processing circuitry (310) is configured to linearly or exponentially interpolate the milling speed or the milling progress.

8. The image processing apparatus (300) according to any one of claims 4 to 7, wherein the processing circuitry (310) is configured to determine the spatial dimension of the ablation region by fitting a predetermined function to a spatial intensity distribution of the light in the image.

9. The image processing apparatus (300) according to claim 8, wherein the predetermined function is a Gaussian function.

10. The image processing apparatus (300) according to any one of claims 8 or 9, wherein the processing circuitry (310) is configured to determine the spatial dimension by determining a peak of the fitted predetermined function.

11. The image processing apparatus (300) according to any one of claims 8 to 10, wherein the processing circuitry (310) is further configured to project the intensity distribution onto an axis and fit the predetermined function to the projected intensity distribution.

12. The image processing apparatus (300) according to any one of claims 4 to 11, wherein the processing circuitry (310) is further configured to determine the spatial dimension of the ablation region by locating a local maximum of a spatial intensity distribution of the light in the image.

13. The image processing apparatus (300) according to any one of claims 4 to 12, wherein the processing circuitry (310) is configured to determine a spatial dimension of a trench milled into the sample.

14. An ion milling method (600), comprising
forming (610) an ion beam from plasma;
radiating (620) the ion beam towards a sample for generating an ablation region, wherein the ion beam emits light towards the sample; and
capturing (630) the light from the ablation region.

15. An image processing method (700), comprising
obtaining (710) an image of the light captured by the optical imaging sensor of the ion milling apparatus according to any one of claims 1 to 3; and
determining (720) a spatial dimension of the ablation region of the sample based on the image.

16. A computer program having a program code for performing a method according to claim 14 when the program is executed on processor.
